# EUROPEAN PATENT APPLICATION

(11) **EP 2 814 076 A1**
(43) Date of publication of application: **17.12.2014**
(21) Application number: 13746416.0
(22) Date of filing: 07.02.2013
(51) Int. Cl.: H01L 51/42

(54) **ORGANIC THIN FILM SOLAR CELL**

(30) Priority: 07.02.2012 JP 2012024451; 21.03.2012 JP 2012063911; 09.10.2012 JP 2012224352
(71) Applicant: Sekisui Chemical Co., Ltd., Osaka-shi, Osaka 530-0047 (JP)
(72) Inventor: HAYAKAWA Akinobu, Mishima-gun Osaka 618-0021 (JP); ITO Kazushi, Mishima-gun Osaka 618-0021 (JP); SUN Ren-de, Mishima-gun Osaka 618-0021 (JP)
(74) Representative: Hart-Davis, Jason
(86) International application number: PCT/JP2013/052796
(87) International publication number: WO 2013/118796

(57) **Abstract**

The present invention aims to provide an organic thin-film solar cell that has a high photoelectric conversion efficiency, little dispersion in the photoelectric conversion efficiency in a photoelectric conversion layer, and excellent durability. The present invention is an organic thin-film solar cell including a photoelectric conversion layer, wherein the photoelectric conversion layer includes a portion containing a sulfide of a Group 15 element in the periodic table and a portion containing an organic semiconductor having a molecular weight of less than 10,000, and the portion containing a sulfide of a Group 15 element in the periodic table and the portion containing an organic semiconductor having a molecular weight of less than 10,000 contact with each other.

## Description

### TECHNICAL FIELD

The present invention relates to an organic thin-film solar cell that has a high photoelectric conversion efficiency, little variation in the photoelectric conversion efficiency in a photoelectric conversion layer, and excellent durability.

### BACKGROUND ART

Photoelectric conversion elements have been developed which include a laminated body of a plurality of kinds of semiconductors and electrodes disposed on both sides of the laminated body. Instead of such a laminated body, use of a composite film produced by mixing a plurality of kinds of semiconductors has also been examined. In such photoelectric conversion elements, each semiconductor acts as a P-type semiconductor or an N-type semiconductor. Photocarriers (electron-hole pairs) are generated by photoexcitation in the P-type semiconductor or N-type semiconductor so that electrons and holes move through the N-type semiconductor and P-type semiconductor, respectively, to create electric fields.

Most photoelectric conversion elements practically used nowadays are inorganic solar cells produced by use of inorganic semiconductors formed of silicon or other materials. Unfortunately, production of inorganic solar cells is costly, and upsizing is difficult, which limits the range of applications. Thus, organic solar cells produced by use of organic semiconductors, instead of inorganic semiconductors, are attracting interest.

Most organic solar cells include fullerenes. Fullerenes are known to act mainly as an N-type semiconductor. For example,

Patent Literature 1 describes a semiconductor hetero-junction film that includes an organic compound which is to act as a P-type semiconductor and fullerenes. However, organic solar cells produced by use of a fullerene are known to deteriorate due to the fullerene (see, for example, Non Patent Literature 1). It is thus necessary to select materials having higher durability than fullerenes.

Few organic semiconductors are excellent enough to replace fullerenes. Thus, studies have been made on organic solar cells in which an inorganic semiconductor is used instead of a fullerene together with an organic semiconductor. Zinc oxide, titanium oxide, or similar materials are used as an inorganic semiconductor, for example. Such an organic solar cell is described in, for example, Patent Literature 2. The organic solar cell includes an active layer containing an organic electron donor and a compound semiconductor crystal between two electrodes. Unfortunately, the organic solar cell fails to achieve sufficient durability even if zinc oxide, titanium oxide, or similar materials are used. Moreover, it has a lower photoelectric conversion efficiency as compared to those including fullerenes.

### CITATION LIST

### - Patent Literature

Patent Literature 1: JP-A 2006-344794
Patent Literature 2: JP-B 4120362

### - Non Patent Literature

Non Patent Literature 1: Reese et al., Adv.Funct.Mater., 20, 3476-3483(2010)

### SUMMARY OF INVENTION

### - Technical Problem

The present invention aims to provide an organic thin-film solar cell that has a high photoelectric conversion efficiency, little variation in the photoelectric conversion efficiency in a photoelectric conversion layer, and excellent durability.

### - Solution to Problem

The present invention relates to an organic thin-film solar cell comprising a photoelectric conversion layer, wherein the photoelectric conversion layer includes a portion containing a sulfide of a Group 15 element in the periodic table and a portion containing an organic semiconductor having a molecular weight of less than 10,000, and the portion containing a sulfide of a Group 15 element in the periodic table and the portion containing an organic semiconductor having a molecular weight of less than 10,000 contact with each other.

The present invention is described in detail below.

The inventors of the present invention have found out that, if an organic thin-film solar cell comprises a photoelectric conversion layer that includes a portion containing a sulfide of a Group 15 element in the periodic table and a portion containing an organic semiconductor having a molecular weight of less than 10,000, the organic thin-film solar cell has an enhanced durability while a high photoelectric conversion efficiency is maintained and, furthermore, has little variation in the photoelectric conversion efficiency in the photoelectric conversion layer. Accordingly, they completed the present invention.

The organic thin-film solar cell of the present invention comprises a photoelectric conversion layer. The photoelectric conversion layer includes a portion containing a sulfide of a Group 15 element in the periodic table (hereinafter, also referred to as a sulfide portion) and a portion containing an organic semiconductor having a molecular weight of less than 10,000 (hereinafter, also referred to as an organic semiconductor portion). Moreover, in the photoelectric conversion layer, the sulfide portion and the organic semiconductor portion contact with each other.

In the photoelectric conversion layer having the aforementioned structure, the sulfide portion and the organic semiconductor portion presumably act mainly as an N-type semiconductor and a P-type semiconductor, respectively. Photocarrier (electron-hole pair) is generated by photoexcitation in the P-type semiconductor or N-type semiconductor. Electrons move through the N-type semiconductor, and holes move through the P-type semiconductor to thereby generate electric fields. Meanwhile, the sulfide portion may partially act as a P-type semiconductor, and the organic semiconductor portion may partially act as an N-type semiconductor.

Due to high durability of sulfides of Group 15 elements in the periodic table, use of a sulfide of a Group 15 element in the periodic table enables the organic thin-film solar cell of the present invention to have excellent durability. Moreover, use of an organic semiconductor enables the organic thin-film solar cell of the present invention to have excellent impact resistance, flexibility, or other properties as well. Furthermore, as the organic semiconductor has a molecular weight of less than 10,000, the organic semiconductor can enter into minute space in the sulfide portion so that it easily fits with the sulfide portion. Thus, the organic thin-film solar cell of the present invention has little variation in the photoelectric conversion efficiency in the photoelectric conversion layer.

The organic thin-film solar cell of the present invention including a combination of the sulfide portion and the organic semiconductor portion has an extremely high charge separation efficiency, and thus achieves a high photoelectric conversion efficiency. In the case where both of the N-type semiconductor and the P-type semiconductor are inorganic semiconductors, solid solutions thereof may form deposits on the interface. In contrast, no deposit of solid solutions occurs in the organic thin-film solar cell of the present invention. Thus, high stability can be achieved even at a high temperature.

The photoelectric conversion layer may have any structure as long as the sulfide portion and the organic semiconductor portion contact with each other. The photoelectric conversion layer may be a laminated body that includes a layer containing a sulfide portion (a layer containing a sulfide of a Group 15 element in the periodic table) and a layer containing an organic semiconductor portion (a layer containing an organic semiconductor having a molecular weight of less than 10,000), or may be a composite film produced by mixing to form a complex of a sulfide portion and an organic semiconductor portion. The photoelectric conversion layer is preferably a composite film as it can enhance the charge separation efficiency of the organic semiconductor portion.

The sulfide of a Group 15 element in the periodic table is preferably antimony sulfide or bismuth sulfide, and more preferably antimony sulfide. Antimony sulfide is very compatible with the organic semiconductor having a molecular weight of less than 10,000 in terms of the energy level. Moreover, it has a higher visible light absorption than conventionally used materials such as zinc oxide or titanium oxide. Thus, if antimony sulfide is used as the sulfide of a Group 15 element in the periodic table, the organic thin-film solar cell has a higher photoelectric conversion efficiency. The sulfide of a Group 15 element in the periodic table may be used alone, or two or more kinds thereof may be used in combination.

The sulfide of a Group 15 element in the periodic table may be a complex sulfide in which two or more kinds of Group 15 elements in the periodic table are present in the same molecule.

The sulfide portion may contain other elements that do not hinder the effects of the present invention in addition to the sulfide of a Group 15 element in the periodic table. Such other elements are not particularly limited, but are preferably any of the elements of fourth, fifth and sixth periods in the periodic table. Specific examples thereof include indium, gallium, tin, cadmium, copper, zinc, aluminum, nickel, silver, titanium, vanadium, niobium, molybdenum, tantalum, iron, and cobalt. Any of these other elements may be used alone, or two or more kinds thereof may be used in combination. Indium, gallium, tin, cadmium, zinc, or copper is especially preferred as the use thereof enhances electron mobility.

The amount of other elements is preferably 50% by weight at the maximum in the sulfide portion. If the amount is not more than 50% by weight, the sulfide portion can maintain a certain level or higher of compatibility with the organic semiconductor having a molecular weight of less than 10,000, which increases the photoelectric conversion efficiency.

The sulfide portion is preferably a crystalline semiconductor. If the sulfide portion is a crystalline semiconductor, electron mobility is enhanced so that the photoelectric conversion efficiency increases.

The crystalline semiconductor refers to a semiconductor whose scattering peaks can be detected by X-ray diffraction measurement or other technique.

Degree of crystallinity may be employed as an index of the crystallinity of the sulfide portion. The degree of crystallinity of the sulfide portion is preferably 30% at the minimum. If the degree of crystallinity is not less than 30%, the electron mobility is enhanced so that the photoelectric conversion efficiency increases. The minimum degree of crystallinity is more preferably 50%, and still more preferably 70%.

The degree of crystallinity can be determined as follows: scattering peaks of a crystalline fraction detected by X-ray diffraction measurement or other technique and halo due to an amorphous fraction are separated by fitting; integrated intensities thereof are determined; and the proportion of the crystalline fraction in the whole is calculated.

In order to increase the degree of crystallinity of the sulfide portion, the sulfide portion may be subjected to, for example, thermal annealing, exposure to strong light such as laser or flash lamp, exposure to excimer light, or exposure to plasma. Exposure to strong light or exposure to plasma, for example, is especially preferred as such a technique enables to suppress oxidation of the sulfide of a Group 15 element in the periodic table.

The organic semiconductor having a molecular weight of less than 10,000 can enter into minute space in the sulfide portion due to the molecular weight of less than 10,000, so that it easily fits with the sulfide portion. Thus, the organic thin-film solar cell of the present invention has little variation in the photoelectric conversion efficiency in the photoelectric conversion layer. The organic semiconductor having a molecular weight of less than 10,000 has a molecular weight of preferably not more than 8,100, more preferably not more than 5,400, and still more preferably not more than 1500. The minimum molecular weight of the organic semiconductor having a molecular weight of less than 10,000 is not particularly limited. The organic semiconductor has a molecular weight of preferably not less than 200 and more preferably not less than 400.

The organic semiconductor having a molecular weight of less than 10,000 may be a low molecular weight compound, or may be an oligomer or a polymer. In the case where the organic semiconductor having a molecular weight of less than 10,000 is an oligomer or a polymer, the molecular weight means the weight average molecular weight.

The organic semiconductor having a molecular weight of less than 10,000 is not particularly limited , and examples thereof include compounds having a thiophene skeleton, a phthalocyanine skeleton, a naphthalocyanine skeleton, a pentacene skeleton, a porphyrin skeleton (e.g., benzoporphyrin skeleton), or the like. Compounds having a thiophene skeleton, a phthalocyanine skeleton, a naphthalocyanine skeleton, or a benzoporphyrin skeleton are especially preferred as they have a relatively high durability.

The organic semiconductor having a molecular weight of less than 10,000 is preferably of donor-acceptor type because such an organic semiconductor can absorb light in a long wavelength range. Donor-acceptor compounds having a thiophene skeleton or donor-acceptor compounds having a naphthalocyanine skeleton are more preferred. Donor-acceptor compounds having a thiophene skeleton and a diketopyrrolopyrrole skeleton are particularly preferred among donor-acceptor compounds having a thiophene skeleton in view of the light absorption wavelength.

The organic thin-film solar cell of the present invention preferably includes the aforementioned photoelectric conversion layer between a pair of electrodes. The materials of the electrodes are not particularly limited, and may be conventional materials. Examples of the materials of the anode include metals such as gold, conductive transparent materials such as CuI, ITO (indium tin oxide), SnO₂, AZO (aluminum zinc oxide), IZO (indium zinc oxide), or GZO (gallium zinc oxide), and conductive transparent polymers. Examples of the materials of the cathode include sodium, sodium-potassium alloys, lithium, magnesium, aluminum, magnesium-silver mixtures, magnesium-indium mixtures, aluminum-lithium alloys, Al/Al₂O₃ mixtures, and Al/LiF mixtures. Any of these materials may be used alone, or two or more kinds thereof may be used in combination.

The organic thin-film solar cell of the present invention may further include a substrate, a hole transport layer, an electron transport layer, or other members. The substrate is not particularly limited, and examples thereof include transparent glass substrates such as soda-lime glass or alkali-free glass, ceramic substrates, and transparent plastic substrates.

The materials of the hole transport layer are not particularly limited. Examples of the materials include P-type conductive polymers, P-type low molecular weight organic semiconductors, P-type metal oxides, P-type metal sulfides, and surfactants. Specific examples thereof include polystyrene sulfonate-doped polyethylene dioxythiophene, carboxyl group-containing polythiophene, phthalocyanine, porphyrin, molybdenum oxide, vanadium oxide, tungsten oxide, nickel oxide, copper oxide, tin oxide, molybdenum sulfide, tungsten sulfide, copper sulfide, tin sulfide or the like, fluoro group-containing phosphonic acid, and carbonyl group-containing phosphonic acid.

The materials of the electron transport layer are not particularly limited. Examples of the materials include N-type conductive polymers, N-type low molecular weight organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, hydroxy quinolinato aluminum, oxadiazol compounds, benzoimidazole compounds, naphthalene tetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

In particular, the organic thin-film solar cell of the present invention preferably includes a photoelectric conversion layer that is a laminated body including a layer containing a sulfide portion (a layer containing a sulfide of a Group 15 element in the periodic table) and a layer containing an organic semiconductor portion (a layer containing organic semiconductor having a molecular weight of less than 10,000) between a pair of electrodes, and further comprises an electron transport layer between one of the electrodes and the layer containing a sulfide portion. The organic thin-film solar cell of the present invention more preferably includes an electron transport layer between one of the electrodes and the layer containing a sulfide portion and a hole transport layer between the other electrode and the layer containing an organic semiconductor portion.

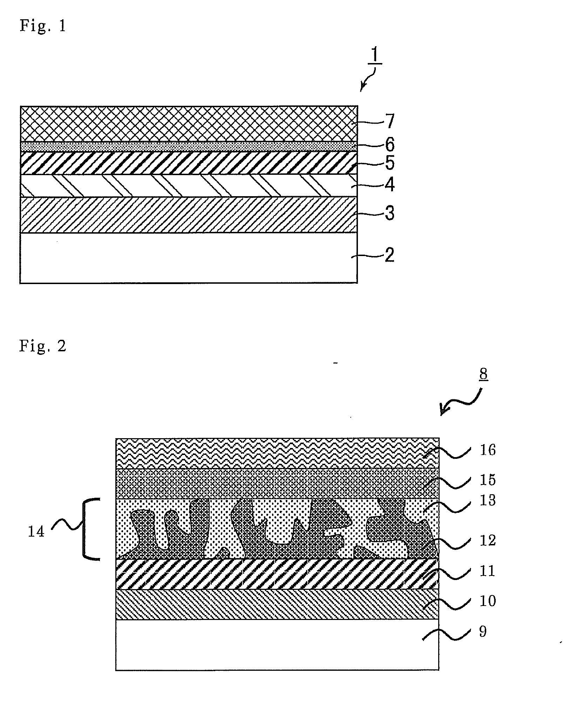

Fig. 1 shows a schematic view of one example of the organic thin-film solar cell of the present invention in which the photoelectric conversion layer is a laminated body. In an organic thin-film solar cell 1 shown in Fig. 1, a substrate 2, a transparent electrode (anode) 3, a layer 4 containing an organic semiconductor portion (a layer containing an organic semiconductor having a molecular weight of less than 10,000), a layer 5 containing a sulfide portion (a layer containing a sulfide of a Group 15 element in the periodic table), an electron transport layer 6, and an electrode (cathode) 7 are laminated in this order.

Preferably, the organic thin-film solar cell of the present invention includes a photoelectric conversion layer that is a composite film formed as a complex containing a mixture of a sulfide portion and an organic semiconductor portion between a pair of electrodes, and further includes an electron transport layer between one of the electrodes and the photoelectric conversion layer. Moreover, the organic thin-film solar cell of the present invention preferably includes an electron transport layer between one of the electrodes and the photoelectric conversion layer, and a hole transport layer between the other electrode and the photoelectric conversion layer.

Fig. 2 shows a schematic view of one example of the organic thin-film solar cell of the present invention in which the photoelectric conversion layer is a composite film. In an organic thin-film solar cell 8 shown in Fig. 2, a substrate 9, a transparent electrode (anode) 10, a hole transport layer 11, a composite film 14 including an organic semiconductor portion 12 and a sulfide portion 13, an electron transport layer 15, and an electrode (cathode) 16 are laminated in this order.

In the case where the photoelectric conversion layer is a laminated body, the layer containing a sulfide portion preferably has a minimum thickness of 5 nm and a maximum thickness of 5000 nm. The layer containing a sulfide portion having a thickness of not smaller than 5 nm can more sufficiently absorb light to thereby increase the photoelectric conversion efficiency. The layer containing a sulfide portion having a thickness of not larger than 5000 nm can prevent generation of regions where charge separation does not occur to thereby avoid reduction in the photoelectric conversion efficiency. The layer containing a sulfide portion more preferably has a minimum thickness of 10 nm and a maximum thickness of 1000 nm, and still more preferably has a minimum thickness of 20 nm and a maximum thickness of 500 nm.

In the case where the photoelectric conversion layer is a laminated body, the layer containing an organic semiconductor portion preferably has a minimum thickness of 5 nm and a maximum thickness of 1000 nm. The layer containing an organic semiconductor portion having a thickness of not smaller than 5 nm can more sufficiently absorb light to thereby increase the photoelectric conversion efficiency. The layer containing an organic semiconductor portion having a thickness of not larger than 1000 nm can prevent generation of regions where charge separation does not occur to thereby avoid reduction in the photoelectric conversion efficiency. The layer containing an organic semiconductor portion more preferably has a minimum thickness of 10 nm and a maximum thickness of 500 nm, and still more preferably has a minimum thickness of 20 nm and a maximum thickness of 200 nm.

The hole transport layer preferably has a minimum thickness of 1 nm and a maximum thickness of 200 nm. The hole transport layer having a thickness of not smaller than 1 nm can more sufficiently block electrons. The hole transport layer having a thickness of not larger than 200 nm tends not to create resistance to hole transport to thereby increase the photoelectric conversion efficiency. The hole transport layer more preferably has a minimum thickness of 3 nm and a maximum thickness of 150 nm, and still more preferably has a minimum thickness of 5 nm and a maximum thickness of 100 nm.

The electron transport layer preferably has a minimum thickness of 1 nm and a maximum thickness of 200 nm. The electron transport layer having a thickness of not smaller than 1 nm can more sufficiently block holes. The electron transport layer having a thickness of not larger than 200 nm tends not to create resistance to electron transport to thereby increase the photoelectric conversion efficiency. The electron transport layer more preferably has a minimum thickness of 3 nm and a maximum thickness of 150 nm, and still more preferably has a minimum thickness of 5 nm and a maximum thickness of 100 nm.

In the case where the photoelectric conversion layer is a composite film as mentioned above, the photoelectric conversion layer preferably has a minimum thickness of 30 nm and a maximum thickness of 3000 nm. The photoelectric conversion layer having a thickness of not smaller than 30 nm can more sufficiently absorb light to thereby increase the photoelectric conversion efficiency. The photoelectric conversion layer having a thickness of not larger than 3000 nm enables electric charge to be easily transferred to the electrodes thereby increase the photoelectric conversion efficiency. The photoelectric conversion layer more preferably has a minimum thickness of 40 nm and a maximum thickness of 1000 nm, and still more preferably has a minimum thickness of 50 nm and a maximum thickness of 500 nm.

In the case where the photoelectric conversion layer is a composite film, the ratio between the sulfide portion and the organic semiconductor portion is very important. The ratio between the sulfide portion and the organic semiconductor portion is preferably 1:9 to 9:1 (volume ratio). If the ratio is within the above range, holes or electrons easily reach the electrodes, which increases the photoelectric conversion efficiency. The ratio is more preferably 2:8 to 8:2 (volume ratio).

The organic thin-film solar cell of the present invention is produced by any method. For example, in the case where the photoelectric conversion layer is a laminated body, the organic thin-film solar cell of the present invention is produced by the following method: an electrode (anode) is formed on a substrate; a layer containing an organic semiconductor portion is formed on a surface of the electrode (anode) by a printing method such as spin coating or a vacuum evaporation method; then a layer containing a sulfide portion is formed on a surface of the layer containing an organic semiconductor portion by a vacuum evaporation method or other methods; and further an electrode (cathode) is formed on a surface of the layer containing a sulfide portion. Alternatively, after an electrode (cathode) is formed on a substrate, a layer containing a sulfide portion, a layer containing an organic semiconductor portion, and an electrode (anode) may be formed in this order.

In the production of the organic thin-film solar cell of the present invention, the organic semiconductor can enter into minute space in the sulfide portion due to the molecular weight of less than 10,000, so that it easily fits with the sulfide portion. Thus, the organic thin-film solar cell of the present invention has little variation in the photoelectric conversion efficiency in the photoelectric conversion layer. Moreover, as the organic semiconductor portion can be stably and simply formed by a printing method such as spin coating, the cost for forming the organic semiconductor portion can be reduced. The sulfide portion may also be formed not by a vacuum evaporation method but by a printing method such as spin coating using a solution of a precursor of a sulfide of a Group 15 element in the periodic table or a dispersion of nano particles of a sulfide of a Group 15 element in the periodic table.

Moreover, in the case where the photoelectric conversion layer is a composite film, for example, the composite film may be formed of a mixed solution of an organic semiconductor having a molecular weight of less than 10,000 and a solution of a precursor of a sulfide of a Group 15 element in the periodic table or a dispersion of nano particles of a sulfide of a Group 15 element in the periodic table. Furthermore, the composite film may also be formed by co-deposition of a sulfide of a Group 15 element in the periodic table and an organic semiconductor having a molecular weight of less than 10,000.

### - Advantageous Effects of Invention

The present invention can provide an organic thin-film solar cell that has a high photoelectric conversion efficiency, little variation in the photoelectric conversion efficiency in the photoelectric conversion layer, and excellent durability.

### BRIEF DESCRIPTION OF DRAWINGS

Fig. 1 is a cross-sectional view schematically showing one example of the organic thin-film solar cell of the present invention in which the photoelectric conversion layer is a laminated body.
Fig. 2 is a cross-sectional view schematically showing one example of the organic thin-film solar cell of the present invention in which the photoelectric conversion layer is a composite film.

### DESCRIPTION OF EMBODIMENTS

The present invention is described in more detail below referring to, but not limited to, examples.

Examples 1 to 11 and Comparative Examples 1 to 16 each describe production of an organic thin-film solar cell in which the photoelectric conversion layer is a laminated body.

### (Example 1)

### <Cathode>

An ITO film having a thickness of 240 nm was formed as a cathode on a glass substrate. The ITO film was subjected to ultrasonic cleaning for 10 minutes each with acetone, methanol, and isopropyl alcohol in this order, followed by drying.

### <Electron transport layer>

An electron transport layer having a thickness of 50nm was formed using a zinc oxide nanoparticle dispersion by spin coating on a surface of the ITO film.

### <Photoelectric conversion layer (laminated body)>

A layer of antimony sulfide having a thickness of 40 nm was formed as a layer containing a sulfide portion (acting mainly as an N-type semiconductor) on a surface of the electron transport layer by vacuum evaporation, and then annealed at a temperature of 260°C for 2 minutes. Thereafter, a layer of a copper phthalocyanine (molecular weight: 576) having a thickness of 30 nm was formed as a layer containing an organic semiconductor portion (acting mainly as a P-type semiconductor) on a surface of the layer containing a sulfide portion by vacuum evaporation.

### <Hole transport layer>

A layer of poly(3,4-ethylene dioxythiophene):poly(styrene sulfonate) (PEDOT:PSS) having a thickness of 50 nm was formed as a hole transport layer on a surface of the layer containing an organic semiconductor portion by spin coating.

### <Anode>

A gold film having a thickness of 100 nm was formed as an anode on a surface of the hole transport layer by vacuum evaporation to thereby give an organic thin-film solar cell.

### (Examples 2 and 3)

Organic thin-film solar cells were produced in the same manner as in Example 1, except that the copper phthalocyanine (molecular weight: 576) was changed to α-6T (α-sexithiophene) (molecular weight: 495) in Example 2 and to pentacene (molecular weight: 278) in Example 3.

### (Example 4)

An organic thin-film solar cell was produced in the same manner as in Example 1, except that, instead of the layer of a copper phthalocyanine (molecular weight: 576), a layer of t-butyl group-containing copper phthalocyanine (produced by Sigma-Aldrich, molecular weight: 800) having a thickness of 20 nm was formed by spin coating.

### (Examples 5 and 6)

Organic thin-film solar cells were produced in the same manner as in Example 1, except that, instead of the layer of a copper phthalocyanine (molecular weight: 576), a layer of a compound 1 (weight average molecular weight: 5,400) having a thickness of 20 nm was formed in Example 5, and a layer of a compound 2 (weight average molecular weight: 8,100) having a thickness of 20 nm was formed in Example 6, by spin coating.

The compounds 1 and 2 are diketopyrrolopyrrole skeleton-containing donor-acceptor polymers having different weight average molecular weights from one another. The compounds 1 and 2 were synthesized as follows.

### (Synthesis of compound 1)

To a nitrogen-purged 25-mL schlenk flask A equipped with a stirrer were introduced 54.0 mg (0.057 mmol) of a diketopyrrolopyrrole derivative, 24.0 mg (0.057 mmol) of 5,5'-bis(4,4,5,5-tetramethyl-1,3,2-dioxaborolane-2-yl)-2,2' -bithiophene, 1.5 mg (5.7 µmol) of triphenylphosphine (PPh₃), 0.96 mL of toluene that had undergone freeze-deaeration three times, and 54.0 µL of Aliquant 336.

Separately, to a nitrogen-purged 25-mL schlenk flask B were introduced 615 mg (2.9 mmol) of tripotassium phosphate (K₃PO₄) and 1.1 mL of distilled water, followed by nitrogen bubbling for 20 minutes. The resulting aqueous solution (107 µL) was added to the schlenk flask A, and then 2.2 mg (2.4 µmol) of tris(dibenzylideneacetone)dipalladium (0) (Pd₂(dba)₃) was added. The mixture was heated to 115°C under nitrogen atmosphere, and reacted for 72 hours at the same temperature. Thereafter, the reaction solution was cooled to room temperature, and then introduced to 200 mL of methanol to deposit polymers.

The deposited polymers were separated by filtration, and dissolved in 60 mL of chloroform. To the solution was added 60 mL of ammonia water, followed by stirring at room temperature for 4 hours. An organic phase was separated out. Then, 60 mL of ethylenediaminetetraacetic acid disodium salt (EDTA₂Na) (about 0.1 mol/L) was added to the organic phase, and stirred at room temperature for 16 hours. Next, an organic phase was again separated out, followed by removing the solvent by evaporation under reduced pressure. The resulting solid after drying was dissolved in about 1 mL of chloroform. The solution was introduced to 500 mL of methanol to thereby deposit polymers. The deposited polymers were separated by filtration, and then washed with methanol, water, and hexane in this order, followed by drying under reduced pressure. In this manner, a compound 1 (blackish green, solid, 10 mg, yield relative to the diketopyrrolopyrrole derivative: 20%) was prepared.

The compound 1 had a number average molecular weight of 4100, and a weight average molecular weight of 5,400. The number average molecular weight and weight average molecular weight were measured with a gel permeation chromatography device (HLC-8020, produced by Tosoh Corporation) in chloroform at 40°C, and calculated based on standard polystyrene.

### (Synthesis of compound 2)

To a nitrogen-purged 25-mL schlenk flask A equipped with a stirrer were introduced 59.8 mg (0.063 mmol) of a diketopyrrolopyrrole derivative (produced by Lumtec), 11.0 mg (0.064 mmol) of 2, 5-thiophenediboronic acid, 59.2 µL of Aliquat 336, 59.2 µL of toluene, and 1.6 mg (6.2 µmol) of triphenylphosphine (PPh₃).

A solution (0.12 mL) of 67.4 mg (0.32 mmol) of tripotassium phosphate (K₃PO₄) in distilled water was mixed with 1.1 mL of toluene, and the mixed solution was added to the schlenk flask A, followed by nitrogen bubbling for 5 minutes. Next, 2. 4 mg (2.6 µmol) of tris (dibenzylideneacetone) dipalladium (0) (Pd₂(dba)₃) was further added. The mixture was heated to 115°C under nitrogen atmosphere and reacted at the same temperature for 72 hours. After the reaction solution was cooled to room temperature, it was introduced to 500 mL of methanol to deposit polymers.

The deposited polymers were separated by filtration, and dissolved in 25 mL of chloroform. To the solution was added 25 mL of ammonia water, followed by stirring for 3 hours. An organic phase was separated out. Then, 75 mg of ethylenediaminetetraacetic acid (EDTA) was added to the organic phase, and stirred at room temperature for 16 hours. Further, 25 mL of water was added and stirred for 12 hours. Next, an organic phase was again separated out, followed by removing the solvent by evaporation under reduced pressure. The resulting solid after drying was dissolved in about 1 mL of chloroform. The solution was introduced to 500 mL of methanol to thereby deposit polymers. The deposited polymers were separated by filtration, and then washed with methanol, water, and hexane in this order, followed by drying under reduced pressure. In this manner, a compound 2 (blackish blue, solid, 32.4 mg, yield relative to the diketopyrrolopyrrole derivative: 60%) was

### prepared.

The compound 2 had a number average molecular weight of 4,000, and a weight average molecular weight of 8,100. The number average molecular weight and weight average molecular weight were measured with a gel permeation chromatography device (HLC-8020, produced by Tosoh Corporation) in chloroform at 40°C, and calculated based on standard polystyrene.

### (Examples 7 to 9)

Organic thin-film solar cells were produced in the same manner as in Example 1, except that the copper phthalocyanine (molecular weight: 576) was changed to zinc phthalocyanine (molecular weight: 579) in Example 7, to alkoxy group-containing zinc phthalocyanine (zinc 1,4,8,11,15,18,22,25-octabutoxy-29H,31H-phthalocyanine, molecular weight: 1163) in Example 8, and to benzoporphyrin (molecular weight: 510) in Example 9.

### (Example 10)

An organic thin-film solar cell was produced in the same manner as in Example 1, except that the copper phthalocyanine (molecular weight: 576) was changed to bicycloporphyrin (molecular weight: 510), and the bicycloporphyrin was converted to benzoporphyrin by thermal treatment at 180°C to form a benzoporphyrin layer.

### (Example 11)

An organic thin-film solar cell was produced in the same manner as in Example 1, except that the antimony sulfide was changed to bismuth sulfide.

### (Comparative Example 1)

An organic thin-film solar cell was produced in the same manner as in Example 1, except that the antimony sulfide was changed to a fullerene, and a layer of poly (3-hexylthiophene) (weight average molecular weight: 40,000) having a thickness of 40 nm was formed by spin coating instead of the layer of copper phthalocyanine (molecular weight: 576).

### (Comparative Examples 2 and 3)

Organic thin-film solar cells were produced in the same manner as in Comparative Example 1, except that the annealing temperature for forming the fullerene layer was changed to 180°C in Comparative Example 2, and the fullerene layer was formed without annealing in Comparative Example 3.

### (Comparative Examples 4 to 7)

Organic thin-film solar cells were produced in the same manner as in Comparative Example 1, except that, instead of the fullerene layer, a layer of zinc oxide nano particles was formed by spin coating in Comparative Example 4, a layer of tin sulfide was formed in Comparative Example 5, a layer of zinc sulfide nano particles was formed by spin coating in Comparative Example 6, and a layer of bismuth sulfide was formed in Comparative Example 7.

### (Comparative Example 8)

### <Anode>

An ITO film having a thickness of 240 nm was formed as an anode on a glass substrate. The ITO film was subjected to ultrasonic cleaning for 10 minutes each with acetone, methanol, and isopropyl alcohol in this order, followed by drying.

### <Photoelectric conversion layer (laminated body)>

A layer of copper sulfide (acting mainly as a P-type semiconductor) having a thickness of 50 nm was formed on a surface of an ITO film by vacuum evaporation. Thereafter, a layer of antimony sulfide having a thickness of 40 nm was formed as a layer containing a sulfide portion (acting mainly as an N-type semiconductor) on a surface of the copper sulfide layer by vacuum evaporation.

### <Electron transport layer>

An electron transport layer having a thickness of 50nm was formed using a zinc oxide nanoparticle dispersion on a surface of the layer containing a sulfide portion by spin coating. The layer was annealed at a temperature of 260°C for 2 minutes.

### <Cathode>

An aluminum film having a thickness of 100 nm was formed as a cathode on a surface of the electron transport layer by vacuum evaporation to thereby give an organic thin-film solar cell.

### (Comparative Example 9)

An organic thin-film solar cell was produced in the same manner as in Example 1, except that a layer of poly(3-hexylthiophene) (weight average molecular weight: 40, 000) having a thickness of 40 nm was formed by spin coating instead of the layer of copper phthalocyanine (molecular weight: 576).

### (Comparative Example 10)

### <Cathode>

An ITO film having a thickness of 240 nm was formed as a cathode on a glass substrate. The ITO film was subjected to ultrasonic cleaning for 10 minutes each with acetone, methanol, and isopropyl alcohol in this order, followed by drying.

### <Photoelectric conversion layer (laminated body)>

A layer of antimony sulfide having a thickness of 40 nm was formed as a layer containing a sulfide portion (acting mainly as an N-type semiconductor) on a surface of the ITO film by vacuum evaporation, and then annealed at a temperature of 260°C for 2 minutes. Thereafter, a layer of a poly(3-hexylthiophene) (weight average molecular weight: 40,000) having a thickness of 40 nm was formed as a layer containing an organic semiconductor portion (acting mainly as a P-type semiconductor) on a surface of the layer containing a sulfide portion by spin coating.

### <Hole transport layer>

A layer of poly(3,4-ethylene dioxythiophene):poly(styrene sulfonate) (PEDOT:PSS) having a thickness of 50 nm was formed as a hole transport layer on a surface of the layer containing an organic semiconductor portion by spin coating.

### <Anode>

A gold film having a thickness of 100 nm was formed as an anode on a surface of the hole transport layer by vacuum evaporation to thereby give an organic thin-film solar cell.

### (Comparative Examples 11 and 12)

Organic thin-film solar cells were produced in the same manner as in Comparative Example 9, except that the annealing temperature for forming the layer containing a sulfide portion was changed to 240°C in Comparative Example 11, and the annealing temperature for forming the layer containing a sulfide portion was changed to 200°C in Comparative Example 12.

### (Comparative Examples 13 to 16)

Organic thin-film solar cells were produced in the same manner as in Example 10, except that, instead of the antimony sulfide layer, a layer of a fullerene derivative was formed by spin coating in Comparative Example 13, a layer of zinc oxide nano particles was formed by spin coating in Comparative Example 14, a layer of zinc sulfide nano particles was formed by spin coating in Comparative Example 15, and a layer of tin sulfide was formed in Comparative Example 16.

Examples 12 to 14 and Comparative Examples 17 to 20 each describe production of an organic thin-film solar cell in which the photoelectric conversion layer is a composite film.

### (Example 12)

An organic thin-film solar cell was produced in the same manner as in Example 1, except that a mixture of antimony sulfide (acting mainly as an N-type semiconductor) and copper phthalocyanine (molecular weight: 576)(acting mainly as a P-type semiconductor) was formed into a composite film having a thickness of 100 nm by co-deposition, and the composite film was annealed at a temperature of 260°C for 2 minutes. The volume ratio between the antimony sulfide and the copper phthalocyanine was 8:2.

### (Examples 13 and 14)

Organic thin-film solar cells were produced in the same manner as in Example 1, except that a mixture of antimony sulfide and copper phthalocyanine (molecular weight: 576) was formed into a composite film having a thickness of 160 nm in Example 13, and a mixture of bismuth sulfide and copper phthalocyanine (molecular weight: 576) was formed into a composite film having a thickness of 160 nm in Example 14, by co-deposition, and the composite films were annealed at a temperature of 260°C for 2 minutes. The volume ratio between the antimony sulfide or bismuth sulfide and the copper phthalocyanine was 6:4.

### (Comparative Example 17)

### <Anode>

An ITO film having a thickness of 240 nm was formed as an anode on a glass substrate. The ITO film was subjected to ultrasonic cleaning for 10 minutes each with acetone, methanol, and isopropyl alcohol in this order, followed by drying.

### <Hole transport layer>

A layer of poly(3,4-ethylene dioxythiophene):poly(styrene sulfonate) (PEDOT:PSS) having a thickness of 50 nm was formed as a hole transport layer on a surface of the ITO film by spin coating.

### <Photoelectric conversion layer (composite film)>

A fullerene derivative (8 parts by weight, PCBM, produced by American Dye Source, Inc.) and poly(3-hexylthiophene) (10 parts by weight, weight average molecular weight 40,000) were dispersed and dissolved in chlorobenzene (600 parts by weight) to prepare a mixed solution. The mixed solution was applied to a surface of the hole transport layer to form a composite film having a thickness of 150 nm.

### <Electron transport layer>

An electron transport layer having a thickness of 50nm was formed using a zinc oxide nanoparticle dispersion on a surface of the photoelectric conversion layer by spin coating.

### <Cathode>

An aluminum film having a thickness of 100 nm as a cathode was formed on a surface of the electron transport layer by vacuum evaporation to give an organic thin-film solar cell.

### (Comparative Examples 18 and 19)

An organic thin-film solar cell was produced in the same manner as in Comparative Example 17, except that the fullerene derivative was changed to zinc oxide nano particles in Comparative Example 18, and to zinc sulfide nano particles in Comparative Example 19.

### (Comparative Example 20)

An organic thin-film solar cell was produced in the same manner as in Comparative Example 17, except that antimony sulfide was used instead of the fullerene derivative, and a compound 3 (weight average molecular weight: 12,100) was used instead of the poly(3-hexylthiophene) (weight average molecular weight: 40,000).

The compound 3 was a diketopyrrolopyrrole skeleton-containing donor-acceptor polymer synthesized as follows.

### (Synthesis of compound 3)

To a nitrogen-purged 25-mL schlenk flask A equipped with a stirrer were introduced 59.8 mg (0.063 mmol) of a diketopyrrolopyrrole derivative (produced by Lumtec), 11.0 mg (0.064 mmol) of 2, 5-thiophenediboronic acid, 59.2 µL of Aliquat 336, 59.2 µL of tetrahydrofuran, and 1.6 mg (6.2 µmol) of triphenylphosphine (PPh₃).

A solution (0.12 mL) of 0.32 mmol of sodium carbonate (Na₂CO₃) in distilled water was mixed with 1.1 mL of tetrahydrofuran, and the mixed solution was added to the schlenk flask A, followed by nitrogen bubbling for 5 minutes. Next, 2. 4 mg (2.6 µmol) of tris (dibenzylideneacetone) dipalladium (0) (Pd₂(dba)₃) was further added. The mixture was heated to 85°C under nitrogen atmosphere and reacted at the same temperature for 72 hours. After the reaction solution was cooled to room temperature, it was introduced to 500 mL of methanol to deposit polymers.

The deposited polymers were separated by filtration, and dissolved in 25 mL of chloroform. To the solution was added 25 mL of ammonia water, followed by stirring for 3 hours. An organic phase was separated out. Then, 75 mg of ethylenediaminetetraacetic acid (EDTA) was added to the organic phase, and stirred at room temperature for 16 hours. Further, 25 mL of water was added and stirred for 12 hours. Next, an organic phase was again separated out, followed by removing the solvent by evaporation under reduced pressure. The resulting solid after drying was dissolved in about 1 mL of chloroform. The solution was introduced to 500 mL of methanol to thereby deposit polymers. The deposited polymers were separated by filtration, and then washed with methanol, water, and hexane in this order, followed by drying under reduced pressure. In this manner, a compound 3 (blackish blue, solid, 32.4 mg, yield relative to the diketopyrrolopyrrole derivative: 42%) was prepared.

The compound 3 had a number average molecular weight of 7600, and a weight average molecular weight of 12,100. The number average molecular weight and weight average molecular weight were measured with a gel permeation chromatography device (HLC-8020, produced by Tosoh Corporation) in chloroform at 40°C, and calculated based on standard polystyrene.

### (Evaluation)

### (1) Measurement of photoelectric conversion efficiency

A power source (Model 236, produced by Keithley Instruments Inc.) was connected between electrodes of an organic thin-film solar cell. The photoelectric conversion efficiency of the organic thin-film solar cell was measured with a solar simulator (produced by Yamashita Denso Corporation) at an intensity of 100 mW/cm². The measured value was standardized based on the photoelectric conversion efficiency in Comparative Example 3 regarded as 1.00 (relative photoelectric conversion efficiency (ratio relative to Comparative Example 3)).

### (2) Measurement of photoelectric conversion efficiency after weathering test

A weathering test was performed by glass sealing an organic thin-film solar cell, and exposing it to light at an intensity of 60 mW/cm² for 24 hours under a temperature of 60°C and a humidity of 35%. The photoelectric conversion efficiency was measured before and after the weathering test in the aforementioned manner. A relative conversion efficiency was determined which is a ratio of the photoelectric conversion efficiency after the weathering test relative to the initial photoelectric conversion efficiency (initial value) regarded as 1.00.

### (3) Variation in the photoelectric conversion efficiency in a photoelectric conversion layer

Four pieces of evaluation cells were produced in a 25-mm-square ITO glass in the same manner as the organic thin-film solar cell production methods in the examples and comparative examples. The photoelectric conversion efficiency of each of the evaluation cells was measured in the aforementioned manner.
Poor: The difference between the maximum value and the minimum value of the photoelectric conversion efficiency was larger than 20% of the maximum value.
Good: The difference between the maximum value and the minimum value of the photoelectric conversion efficiency was not larger than 20% of the maximum value.

### (4) Comprehensive evaluation

Each cell was comprehensively evaluated according to the following criteria.
Poor: The relative photoelectric conversion efficiency (ratio relative to Comparative Example 3) was not more than 1; the relative conversion efficiency after the weathering test (ratio relative to the initial value) was not more than 0.8; or the variation in the photoelectric conversion efficiency was evaluated as "Poor".
Good: The relative photoelectric conversion efficiency (ratio relative to Comparative Example 3) was more than 1; the relative conversion efficiency after the weathering test (ratio relative to the initial value) was more than 0.8; and the variation in the photoelectric conversion efficiency was evaluated as "Good".

**Table 1**

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| Electron transport layer | | Zinc oxide | Zinc oxide | Zinc oxide | Zinc oxide | Zinc oxide | Zinc oxide | Zinc oxide | Zinc oxide | Zinc oxide | Zinc oxide | Zinc oxide |
| Hole transport layer | | PEDOT:PSS | PEDOT:PSS | PEDOT:PSS | PEDOT:PSS | PEDOT:PSS | PEDOT:PSS | PEDOT:PSS | PEDOT:PSS | PEDOT:PSS | PEDOT:PSS | PEDOT:PSS |
| Photoelectric conversion layer (Laminated body) | N-type semiconductor | Antimony sulfide | Antimony sulfide | Antimony sulfide | Antimony sulfide | Antimony sulfide | Antimony sulfide | Antimony sulfide | Antimony sulfide | Antimony sulfide | Antimony sulfide | Bismuth sulfide |
| | P-type semiconductor | Copper phthalocyanine (molecular weight 576) | *α*-6T (*α-*sexithiophene) (molecular weight 495) | Pentacene (molecular weight 278) | t-Butyl group-containing copper phthalocyanine (molecular weight: 800) | Compound 1 (weight average molecular weight 5,400) | Compound 2 (weight average molecular weight 8,100) | Zinc phthalocyanine (molecular weight 579) | Alkoxy group-containing zinc phthalocyanine (molecular weight: 1,163) | Benzoporphyrin (molecular weight 510) | Benzoporphyrin (converted from bicycloporphyrin) (molecular weight 510) | Copper phthalocyanine (molecular weight 576) |
| Annealing temperature | | 260 | 260 | 260 | 260 | 260 | 260 | 260 | 260 | 260 | 260 | 260 |
| Evaluation | Relative photoelectric conversion efficiency (ratio relative to Comparative Example 3) | 4.6 | 3.8 | 3.6 | 3.7 | 4.6 | 4.6 | 4.6 | 2.6 | 4.4 | 4.8 | 2.5 |
| | Relative conversion efficiency after westhering test (24 hours) (ratio relative to initial value) | 1 | 0.9 | 0.9 | 1 | 0.9 | 0.9 | 1 | 0.9 | 0.9 | 0.9 | 0.9 |
| | Variation in the photoelectric conversion efficiency | Good | Good | Good | Good | Good | Good | Good | Good | Good | Good | Good |
| | Comprehensive evaluation | Good | Good | Good | Good | Good | Good | Good | Good | Good | Good | Good |

**Table 2**

| | | Comparative Example 1 | Comparative Example 2 | Comparative Example 3 | Comparative Example 4 | Comparative Example 5 | Comparative Example 6 |
|---|---|---|---|---|---|---|---|
| Electron transport layer | | Zinc oxide | Zinc oxide | Zinc oxide | Zinc oxide | Zinc oxide | Zinc oxide |
| Hole transport layer | | PEDOT:PSS | PEDOT:PSS | PEDOT:PSS | PEDOT:PSS | PEDOT:PSS | PEDOT:PSS |
| Photoelectric conversion layer (Laminated body) | N-type semiconductor | Fullerene | Fullerene | Fullerene | Zinc oxide | Tin sulfide | Zinc sulfide |
| | P-type semiconductor | Poly(3-hexylthiophene) (weight average molecular weight: 40,000) | Poly(3-hexylthiophene) (weight average molecular weight: 40,000) | Poly(3-hexylthiophene) (weight average molecular weight: 40,000) | Poly(3-hexylthiophene) (weight average molecular weight: 40,000) | Poly(3-hexylthiophene) (weight average molecular weight: 40,000) | Poly(3-hexylthiophene) (weight average molecular weight: 40,000) |
| Annealing temperature | | 260 | 180 | - | 260 | 260 | 260 |
| Evaluation | Relative photoelectric conversion efficiency (ratio relative to Comparative Example 3) | 0.5 | 0.8 | 1 | 1 | 0.7 | 0.8 |
| | Relative conversion efficiency after weathering test (24 hours) (ratio relative to initial value) | 0.4 | 0.4 | 0.4 | 0.3 | 0.3 | 0.4 |
| | Variation in the photoelectric conversion efficiency | Poor | Poor | Poor | Poor | Poor | Poor |
| | Comprehensive evaluation | Poor | Poor | Poor | Poor | Poor | Poor |

**Table 3**

| | | Comparative Example 7 | Comparative Example 8 | Comparative Example 9 | Comparative Example 10 | Comparative Example 11 | Comparative Example 12 | Comparative Example 13 | Comparative Example 14 | Comparative Example 15 | Comparative Example 16 |
|---|---|---|---|---|---|---|---|---|---|---|---|
| Electron transport layer | | Zinc oxide | Zinc oxide | Zinc oxide | - | Zinc oxide | Zinc oxide | Zinc oxide | Zinc oxide | Zinc oxide | Zinc oxide |
| Hole transport layer | | PEDOT:PSS | - | PEDOT:PSS | PEDOT:PSS | PEDOT:PSS | PEDOT:PSS | PEDOT:PSS | PEDOT:PSS | PEDOT:PSS | PEDOT:PSS |
| Photoelectric conversion layer (Laminated body) | N-type semiconductor | Bismuth sulfide | Antimony sulfide | Antimony sulfide | Antimony sulfide | Antimony sulfide | Antimony sulfide | Fullerene derivative | Zinc oxide | Zinc sulfide | Tin sulfide |
| | P-type semiconductor | Poly(3-hexylthiophene) (weight average molecular weight: 40,000) | Copper sulfide | Poly(3-hoxylthiophene) (weight average molecular weight: 40,000) | Poly(3-hexylthiophene) (weight average molecular weight: 40,000) | Poly(3-hexylthiophene) (weight average molecular weight: 40,000) | Poly(3-hexylthiophene) (weight average molecular weight: 40,000) | Benzoporphyrin (converted from bicycloporphyrin) (molecular weight: 510) | Benzoporphyrin (converted from bicycloporphyrin) (molecular weight: 510) | Benzoporphyrin (converted from bicycloporphyrin) (molecular weight 510) | Benzoporphyrin (converted from bicycloporphyrin) (molecular weight: 510) |
| Annealing temperature | | 260 | 260 | 260 | 260 | 240 | 200 | 260 | 260 | 260 | 260 |
| Evaluation | Relative photoelectric conversion efficiency (ratio relative to Comparative Example 3) | 3 | 0.2 | 5.8 | 3.8 | 32 | 2.4 | 1.5 | 0.8 | 0.8 | 0.6 |
| | Relative conversion efficiency after weathering test (24 hours) (ratio relative to initial value) | 1 | 1 | 1 | 1 | 1 | 1 | 0.4 | 0.8 | 0.9 | 0.9 |
| | Variation in the photoelectric conversion efficiency | Poor | Poor | Poor | Poor | Poor | Poor | Good | Good | Good | Good |
| | Comprehensive evaluation | Poor | Poor | Poor | Poor | Poor | Poor | Poor | Poor | Poor | Poor |

**Table 4**

| | | Example 12 | Example 13 | Example 14 | Comparative Example 17 | Comparative Example 18 | Comparative Example 19 | Comparative Example 20 |
|---|---|---|---|---|---|---|---|---|
| Electron transport layer | | Zinc oxide | Zinc oxide | Zinc oxide | Zinc oxide | Zinc oxide | Zinc oxide | Zinc oxide |
| Hole transport layer | | PEDOT:PSS | PEDOT:PSS | PEDOT:PSS | PEDOT:PSS | PEDOT:PSS | PEDOT:PSS | PEDOT:PSS |
| Photoelectric conversion layer (Composite film) | N-type semiconductor | Antimony sulfide | Antimony sulfide | Bismuth sulfide | Fullerene derivative | Zinc oxide | Zinc sulfide | Antimony sulfide |
| | P-type semiconductor | Copper phthalocyanine (molecular weight 576) | Copper phthalocyanine (molecular weight 576) | Copper phthalocyanine (molecular weight 576) | Poly(3-hexylthiophene) (weight average molecular weight 40,000) | Poly(3-hexylthiophene) (weight average molecular weight 40.000) | Poly(3-hexylthiophene) (weight average molecular weight 40.000) | Compound 3 (weight average molecular weight 12,100) |
| Evaluation | Relative photoelectric conversion efficiency (ratio relative to Comparative Example 3) | 5.8 | 7.2 | 1.7 | 5.4 | 3.8 | 1 | 0.7 |
| | Relative conversion efficiency after weathering test (24 hours) (ratio relative to initial value) | 1 | 1 | 1 | 0.3 | 0.3 | 0.4 | 0.9 |
| | Variation in the photoelectric conversion efficiency | Good | Good | Good | Poor | Poor | Poor | Poor |
| | Comprehensive evaluation | Good | Good | Good | Poor | Poor | Poor | Poor |

### INDUSTRIAL APPLICABILITY

The present invention enables to provide an organic thin-film solar cell that has a high photoelectric conversion efficiency, little variation in the photoelectric conversion efficiency in the photoelectric conversion layer, and excellent durability.

### REFERENCE SIGNS LIST

1 Organic thin-film solar cell
2 Substrate
3 Transparent electrode (anode)
4 Layer containing an organic semiconductor portion (layer containing an organic semiconductor having a molecular weight of less than 10,000)
5 Layer containing a sulfide portion (layer containing a sulfide of a Group 15 element in the periodic table)
6 Electron transport layer
7 Electrode (cathode)
8 Organic thin-film solar cell
9 Substrate
10 Transparent electrode (anode)
11 Hole transport layer
12 Organic semiconductor portion
13 Sulfide portion
14 Composite film
15 Electron transport layer
16 Electrode (cathode)

## Claims

1. An organic thin-film solar cell comprising a photoelectric conversion layer,
wherein the photoelectric conversion layer includes a portion containing a sulfide of a Group 15 element in the periodic table and a portion containing an organic semiconductor having a molecular weight of less than 10,000, and
the portion containing a sulfide of a Group 15 element in the periodic table and the portion containing an organic semiconductor having a molecular weight of less than 10,000 contact with each other.

2. The organic thin-film solar cell according to claim 1,
wherein the sulfide of a Group 15 element in the periodic table is antimony sulfide.

3. The organic thin-film solar cell according to claim 1 or 2,
wherein the photoelectric conversion layer is a laminated body including a layer containing a sulfide of a Group 15 element in the periodic table and a layer containing an organic semiconductor having a molecular weight of less than 10,000.

4. The organic thin-film solar cell according to claim 3,
wherein the photoelectric conversion layer that is a laminated body including a layer containing a sulfide of a Group 15 element in the periodic table and a layer containing an organic semiconductor having a molecular weight of less than 10,000 is disposed between a pair of electrodes, and
the organic thin-film solar cell further comprises an electron transport layer between one of the electrodes and the layer containing a sulfide of a Group 15 element in the periodic table, and a hole transport layer between the other electrode and the layer containing an organic semiconductor having a molecular weight of less than 10,000.

5. The organic thin-film solar cell according to claim 1 or 2,
wherein the photoelectric conversion layer is a composite film formed as a complex containing a mixture of the portion containing a sulfide of a Group 15 element in the periodic table and the portion containing an organic semiconductor having a molecular weight of less than 10,000.

6. The organic thin-film solar cell according to claim 5,
wherein the photoelectric conversion layer that is a composite film formed as a complex containing a mixture of the portion containing a sulfide of a Group 15 element in the periodic table and the portion containing an organic semiconductor having a molecular weight of less than 10,000 is disposed between a pair of electrodes, and
the organic thin-film solar cell further comprises an electron transport layer between one of the electrodes and the photoelectric conversion layer and a hole transport layer between the other electrode and the photoelectric conversion layer.
